(19) Europäisches Patentamt
European Patent Office
Office européen des brevets

(11) **EP 0 998 082 A1**

(12) **DEMANDE DE BREVET EUROPEEN**

(43) Date de publication:
**03.05.2000 Bulletin 2000/18**

(51) Int Cl.[7]: **H04L 25/02**, H03K 19/00

(21) Numéro de dépôt: **99402681.3**

(22) Date de dépôt: **28.10.1999**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **30.10.1998 FR 9813640**

(71) Demandeur: **BULL S.A.**
**78430 Louveciennes (FR)**

(72) Inventeurs:
• **Boudry, Jean-Marie**
**78650 Beynes (FR)**
• **Duhalde, Marcelo**
**78450 Villepreux (FR)**

(54) **Liaison CMOS bidirectionnelle adaptée en réception et en émission**

(57) La présente invention concerne une liaison CMOS bidirectionnelle bipoint du type comportant une ligne de transmission (AB) adaptée reliant respectivement à ses deux extrémités deux circuits intégrés comportant respectivement un dispositif émetteur-récepteur comportant un étage émetteur (7;20) et un étage récepteur (10), en interface sur la ligne et commandé pour émettre ou recevoir des données numériques échangées sur la ligne de transmission (AB) en fonction d'un signal de commande (émission_gd) pour être soit en mode émission, soit en mode réception, les dispositifs émetteur-récepteur n'étant jamais simultanément dans le même mode. La liaison est caractérisée en ce que chaque dispositif émetteur-récepteur comporte au moins un transistor MOSP ($M_A$) et un transistor MOSN ($M_B$) commandés respectivement par le signal de commande dimensionnés et agencés pour adapter la liaison (AB) aux deux extrémités de la ligne de transmission (AB).

FIG. 6

# Description

La présente invention concerne les transmissions de données numériques échangées entre des circuits intégrés en utilisant des liaisons CMOS bidirectionnelles bipoints adaptées en émission et en réception.

L'augmentation des débits de données échangées entre un plus grand nombre de processeurs nécessite des liaisons adaptées pour transmettre ces données d'un bout à l'autre de la liaison tout en garantissant leur intégrité.

En effet pour des débits élevés, c'est-à-dire des fréquences élevées, il faut tenir compte de l'inductance et de la capacitance du support de transmission, dont les effets font que les variations de potentiels se propagent sous forme d'ondes progressives le long du support.

La vitesse de propagation de cette onde sur la ligne est fonction de l'inductance et de la capacitance de la ligne qui définissent alors l'impédance caractéristique de la ligne.

Toute variation d'impédance ou désadaptation provoque une variation de la vitesse de propagation de l'onde qui se décompose alors en une onde transmise et une onde réfléchie qui peuvent interférer et conduire à une perte partielle ou totale des informations échangées sur la ligne.

Pour éviter ce phénomène, on fait en sorte que la ligne possède une structure et donc une impédance caractéristique constante sur toute sa longueur.

Cependant il est difficile d'éviter les phénomènes de désadaptation liés notamment aux différents branchements sur la ligne, en particulier les connexions des processeurs sur la ligne.

De façon générale, une transmission bidirectionnelle nécessite au niveau de chaque processeur la présence d'un étage tampon à la fois émetteur et récepteur, appelé également "buffer" bidirectionnel, couplé à la ligne de transmission par une impédance d'adaptation.

La ligne de transmission tout en étant adaptée peut conserver certaines imperfections.

Le sens de transmission doit pouvoir être bidirectionnel, c'est-à-dire que sous le contrôle d'un signal de commande déterminé, chaque extrémité de la liaison peut être tantôt réceptrice, tantôt émettrice.

On peut choisir de faire des transmissions bidirectionnelles simultanément dans les deux sens ou non , mais l'option de transmission simultanée nécessite des buffers de conception extrêmement délicate capables de séparer les données émises des données reçues.

On connaît une liaison de type GTL, abréviations anglo-saxonnes pour "Gunning Transceiver Logic" spécifiquement conçue pour réaliser des transmissions multipoints et donc capable de gérer des transmissions bipoints bidirectionnelles. Ce type de liaison est défini par le standard JEDEC et a fait l'objet d'un brevet US5023488A, intitulé "Drivers and receivers for interfacing VLSI CMOS circuits to transmission lines".

Cependant, si cette solution convient bien a des transmissions multipoints, elle est néanmoins lourde à utiliser dans le cas de liaisons bipoints. Elle a notamment pour inconvénient de ne pas utiliser toutes les capacités du GTL destiné à gérer des liaisons multipoints, tout en devant en gérer les inconvénients.

Ces inconvénients sont notamment des courants et des pics de courant élevés, une alimentation spécifique, et une tension de référence à générer et à distribuer.

On connaît également des dispositifs d'adaptation basés sur des barrettes de résistances de grande précision et de valeur ajustable, disposées en dehors des boîtiers. Ces barrettes présentent un encombrement qui n'est plus négligeable sur des cartes dont les dimensions déjà limitées supportent un nombre de processeurs toujours grandissant.

On connaît des circuits intégrés comportant une ou plusieurs conductances réglées sur une valeur de consigne. L'intégration de conductances dans le circuit intégré permet un gain de place appréciable et réduit le problème de connexions.

Un tel circuit est notamment décrit dans le brevet français n° 2 730 365 déposé par la demanderesse et intitulé "Circuit intégré avec conductance réglable à partir d'un signal numérique de commande". Ce document décrit un circuit intégré comportant au moins une conductance réglable à partir d'un signal numérique de consigne codant des échelons de valeur pour discrétiser une valeur exacte avec une précision relative fixée. La conductance est constituée de conductances élémentaires définissant chacune un échelon de valeur, tel que chaque conductance élémentaire est dimensionnée de façon à ce qu'à deux échelons de valeur successifs du signal numérique de consigne corresponde un seul échelon de valeur de la conductance. S'il résulte du premier des deux échelons de valeur du signal numérique de consigne une valeur inférieure, respectivement supérieure, à la valeur exacte, conductance élémentaire correspondante est activée, respectivement désactivée. Ainsi, la valeur totale ajustée de conductance est égale à la valeur exacte avec la même précision relative, sans osciller entre deux valeurs encadrant cette valeur exacte.

Ce type de solution nécessite une logique complexe pour élaborer un signal de consigne permettant de commander les conductances servant à l'adaptation du circuit intégré. Cette logique de commande est de mise en oeuvre relativement lourde et augmente de façon non négligeable la taille du circuit intégré recevant ces conductances d'adaptation.

Un but de la présente invention est d'obtenir des performances équivalentes à celles obtenues sur une liaison de type GTL pour la transmission des données au premier "aller" des signaux, sans attendre un "aller-retour" sur la ligne, tout en ayant des contraintes plus faibles sur l'environnement : courants, alimentations, encapsulation (packaging).

A cet effet, l'invention a pour premier objet une liaison CMOS bidirectionnelle bipoint du type comportant une ligne de transmission adaptée reliant respectivement à ses deux extrémités deux circuits intégrés comportant respectivement un dispositif émetteur-récepteur comportant un étage émetteur et un étage récepteur, en interface sur la ligne et commandé pour émettre ou recevoir des données numériques échangées sur la ligne de transmission en fonction d'un signal de commande pour être soit en mode émission, soit en mode réception, les dispositifs émetteur-récepteur n'étant jamais simultanément dans le même mode.

Selon l'invention, la liaison est caractérisée en ce que chaque dispositif émetteur-récepteur comporte au moins un transistor MOSN et un transistor MOSP commandés respectivement par le signal de commande, dimensionnés et agencés pour adapter la liaison aux deux extrémités de la ligne de transmission.

Selon une caractéristique, les transistors MOSN et MOSP sont dimensionnés et agencés pour se comporter comme des résistances d'adaptation, en mode réception.

Selon une autre caractéristique, les résistances d'adaptation ont des caractéristiques paraboliques et leur somme algébrique définit une caractéristique quasi linéaire dont la pente est sensiblement égale à la valeur de l'impédance caractéristique de la ligne de transmission.

L'invention a notamment pour avantage d'amortir les effets dus au boîtier, vu du côté récepteur, et d'utiliser les transistors des buffers, implantés sur le circuit intégré, pour réaliser l'adaptation de la liaison tout en réduisant le nombre et la taille des transistors MOS.

L'invention n'utilise pas des signaux de commande particuliers mais uniquement les signaux de validation des dispositifs émetteur-récepteur des circuits intégrés.

Un autre avantage est de supprimer le besoin de résistances externes entraînant un moindre coût, et donc de faciliter le tracé de la carte imprimée.

Cet avantage est loin d'être négligeable et peut même devenir primordial quand on envisage des centaines et même au-delà du millier de liaisons à partir d'un même boîtier.

Un autre avantage de résistances d'adaptation intégrées selon l'invention, est que si la dispersion technologique est telle que les transistors MOSP et MOSN ont une dispersion d'appariement par rapport à une technologie parfaitement centrée, le sens de variation du générateur de tension de Thévenin, équivalent des résistances intégrées, varie dans le même sens que la tension de basculement de l'inverseur utilisé en détecteur d'entrée. Il y a donc au moins une compensation partielle des dispersions.

Enfin, l'implantation des résistances terminales $R_T$ sur le circuit intégré est ce qui donne la meilleure atténuation des oscillations parasites induites par les désadaptations du fait des connecteurs du boîtier.

D'autres avantages et caractéristiques de la présente invention apparaîtront à la lecture de la description qui suit faite en référence aux figures annexées qui représentent :

- la figure 1, un schéma de principe d'une liaison monodirectionnelle CMOS adaptée en émission et en réception ;
- la figure 1a, un schéma électrique d'un émetteur représenté par un inverseur sur la figure 1 ;
- la figure 1b, le schéma équivalent de l'émetteur ;
- la figure 2, un schéma de principe d'une liaison bidirectionnelle adaptée en réception en utilisant des résistances fixes ;
- la figure 2a, le schéma équivalent de l'émetteur de la liaison bidirectionnelle de la figure 2 ;
- les figures 3a et 3b, respectivement deux exemples de schémas d'émetteurs à trois états ;
- la figure 4, un schéma de principe d'un buffer bidirectionnel d'une liaison selon l'invention, avec des résistances commandées distinctes de l'émetteur ;
- la figure 5, le schéma électrique du buffer de la figure 4 ;
- la figure 5a, le schéma comportemental des étages de commutation du buffer de la figure 4 en émission ;
- la figure 5b, le schéma équivalent du buffer de la figure 4 en émission ;
- la figure 5c, le schéma comportemental des étages de commutation du buffer de la figure 4 en réception ;
- la figure 5d, le schéma équivalent du buffer de la figure 4 en réception ;
- la figure 6, un schéma électrique d'un buffer d'une liaison selon l'invention avec des résistances commandées et fusionnées avec l'émetteur ;
- la figure 6a, le schéma comportemental des étages de commutation du buffer de la figure 6, en émission ;
- la figure 6b, le schéma équivalent du buffer de la figure 6, en émission ;
- la figure 6c, le schéma comportemental des étages de commutation du buffer de la figure 6, en réception ;
- la figure 6d, le schéma équivalent du buffer de la figure 6, en réception ;
- la figure 7, un schéma de principe d'un émetteur mixte ayant une résistance à l'émission inférieure à la résistance à la réception ;
- la figure 8, un schéma de principe d'un émetteur mixte ayant une résistance à l'émission inférieure à la résistance à la réception avec un réglage d'impédance indépendant à l'émission et à la réception ;
- la figure 9, un schéma de principe d'un émetteur mixte ayant une résistance à l'émission inférieure à la résistance à la réception, avec des réglages d'impédance indépendants à l'émission et à la réception ;

- la figure 10, le schéma électrique des étages de commutation du buffer de la figure 6 ;

- la figure 11, la réponse d'un buffer selon la figure 7 configuré en émetteur WC et en récepteur BC, à un train d'impulsions dans le cas réel ;

- la figure 12, la réponse d'un buffer selon la figure 7 configuré en émetteur BC et en récepteur BC, à un train d'impulsions dans le cas réel ;

- la figure 13, la réponse d'un buffer selon la figure 7 configuré en émetteur WC et en récepteur WC, à un train d'impulsions dans le cas réel ;

- la figure 14, la réponse d'un buffer selon la figure 7 configuré en émetteur BC et en récepteur WC, à un train d'impulsions dans le cas réel ;

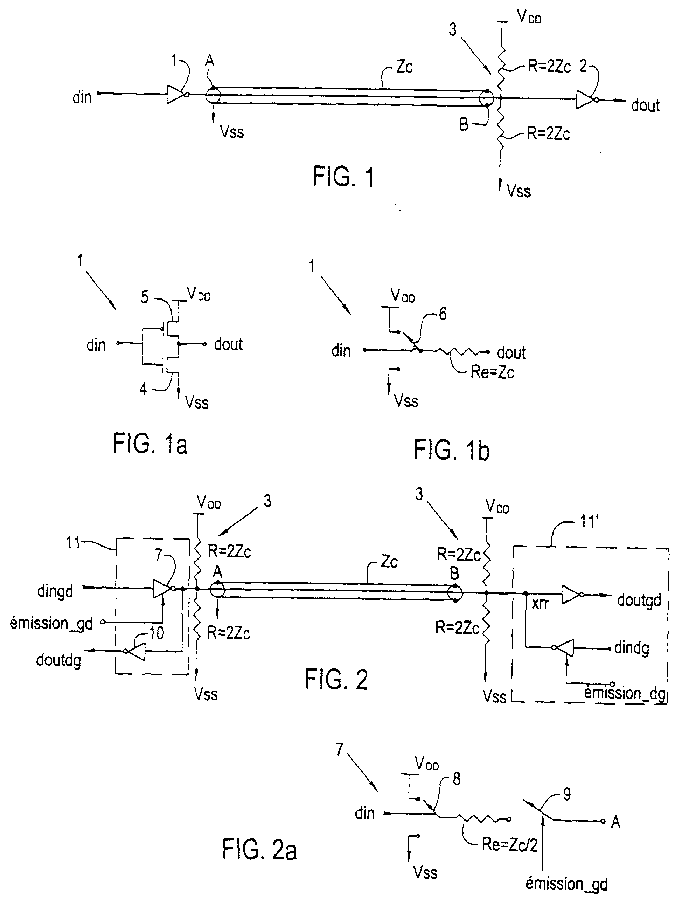

- la figure 1 5, le schéma électrique des transistors MOS d'adaptation montés en résistances d'adaptation ; et

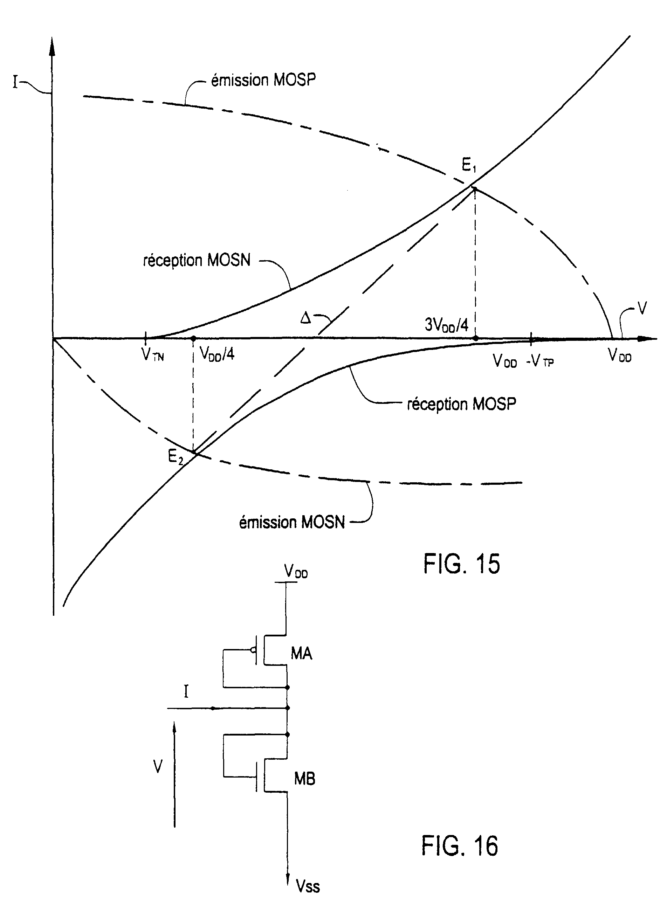

- la figure 16, un diagramme de la résolution graphique du dimensionnement des transistors MOS d'adaptation.

Sur ces figures, les mêmes éléments sont désignés par le même repère.

La figure 1 illustre schématiquement un exemple de liaison CMOS monodirectionnelle en émission et en réception, adaptée à ses deux extrémités.

On a représenté une ligne de transmission AB de longueur déterminée et d'impédance caractéristique $Z_C$ reliant un émetteur 1 connecté à son entré A, à un récepteur 2 connecté à sa sortie B. L'émetteur 1 et le récepteur 2 sont représentés respectivement par un inverseur. Un pont 3 de deux résistances, respectivement de valeur $R = 2Z_C$, est connecté en B. Le pont 3 est alimenté entre une tension d'alimentation haute $V_{DD}$ et une tension d'alimentation basse $V_{SS}$.

Vu du côté récepteur 2, le pont de résistances 3 présente un schéma de Thévenin équivalent d'impédance $Z_C$ en série avec un générateur de tension de valeur égale à $V_{DD}/2$.

La figure 1a illustre le schéma électrique de l'émetteur 1, réalisé à partir d'un CMOS constitué d'un transistor MOSN 4 et d'un transistor MOSP 5 montés de manière connue.

La figure 1b illustre le schéma équivalent de l'émetteur 1 se comportant comme un inverseur 6 commandé par un signal de commande din et délivrant un signal de sortie dout.

Si le dimensionnement des transistors est correct, c'est-à-dire si les résistances équivalentes des transistors MOSN 4 et MOSP 5 sont de valeur identique, le schéma équivalent peut se réduire à une résistance $R_T = Z_C$ commutée entre $V_{DD}$ et $V_{SS}$, $R_T$ sera appelée par la suite, résistance terminale du schéma équivalent de Thévenin de l'émetteur ou du récepteur.

Dans ces conditions, l'amplitude des signaux transmis est égale à $V_{DD}/2$ centré sur $V_{DD}/2$, ce qui signifie que le niveau bas transmis est égal à $V_{DD}/4$ et le niveau haut à $3V_{DD}/4$.

Le coefficient de réflexion à une extrémité quelconque de la ligne est égale à :

$$C_{reflex} = (R_T - Z_C) / (R_T + Z_C) \qquad (1)$$

$C_{reflex}$ est compris entre -1 (quand la ligne est branchée sur un court-circuit ou sur un générateur de tension pur, dans ce cas $R_T = 0$) et +1 (quand l'extrémité de la ligne est en l'air ou branchée sur un générateur de courant).

$$C_{reflex} = 0 \text{ quand } R_T = Z_C.$$

L'intérêt de l'adaptation aux deux extrémités est que si l'adaptation n'est pas parfaite, la résistance terminale s'exprime par :

$$R_T = Z_C(1 + \varepsilon R) \qquad (2)$$

d'où $C_{reflex} = \varepsilon_R / (2 + \varepsilon_R)$ voisin de $\varepsilon_R / 2$ quand $\varepsilon_R$ est petit en pourcentage.

Par exemple, si la résistance terminale $R_T$ est à +/- 20% de la valeur $Z_C$ à chaque extrémité de la ligne, la première réflexion a une amplitude de 10% du premier signal transmis, la seconde réflexion du coté récepteur aura une amplitude de 1% du premier signal.

La seconde réflexion se mélange avec le nouveau signal émis, car on n'attend pas qu'un signal soit arrivé pour émettre le suivant. Il est donc important que l'atténuation des réflexions après un "aller-retour-aller" soit forte pour éviter des intermodulations de signaux. Ces réflexions multiples sont vues comme un bruit pour les signaux transmis au premier "aller".

On constate donc que la double adaptation même non parfaite conduit à de fortes atténuations des réflexions et garantit donc une bonne intégrité des signaux transmis.

Un autre effet de l'adaptation en réception est l'atténuation et l'amortissement des signaux parasites oscillatoires induits par des désadaptations locales telles que les traversées des connecteurs intermédiaires et des connecteurs du boîtier des circuits intégrés.

Quand on ne peut pas assurer une adaptation exacte, il vaut mieux en réception avoir $R_T > Z_C$ avec un coefficient Creflex > 0 , ce qui augmente l'amplitude du signal reçu, et en émission $R_T < Z_C$, ce qui augmente également l'amplitude du signal émis.

Le bruit généré par les réflexions multiples sera en effet d'autant plus "tolérable" que les niveaux transmis sont élevés.

On désignera par le critère CNOP, abréviations de "Critère de Non Optimisation Préférable", cette tolérance de désadaptation.

Le schéma de la figure 2 illustre la liaison précédente modifiée pour réaliser une liaison bidirectionnelle, avec des résistances fixes pour conserver l'adaptation en réception.

Les extrémités de la ligne AB sont couplées respectivement au point milieu d'un pont de résistances 3 similaire à celui de la figure 1.

L'émetteur utilisé pour une liaison bidirectionnelle est un amplificateur 7 "tristates", ou trois états, dont le schéma équivalent est illustré à la figure 2a dans son état actif, c'est-à-dire quand le premier inverseur 8 commandé est branché sur $V_{DD}$ (ou $V_{SS}$).

Pour conserver une même amplitude des signaux autour de $V_{DD}/2$, il faut que l'amplificateur 7 présente une résistance équivalente Re = $Z_C /2$.

On a représenté un deuxième interrupteur 9 en série avec la résistance équivalente Re. Ce deuxième interrupteur 9 est commandé par un signal de validation qui à l'état logique "1" commande l'émission et qui à l'état logique "0" met l'émetteur dans l'état haute impédance ; l'amplificateur 7 est désactivé et peut être alors considéré comme un circuit ouvert au point A.

Pour la réception, un récepteur ou un buffer de réception 10, également représenté comme un inverseur, est couplé au point A et délivre le signal doutdg véhiculé par la ligne de transmission AB. L'amplificateur trois états 7 et le récepteur 10 constituent un étage émetteur-récepteur bidirectionnel appelé également buffer bidirectionnel 11 et délimité par une ligne fermée discontinue.

On a représenté de manière symétrique au point B, un buffer bidirectionnel 11' identique au buffer 11.

Du fait de cette symétrie, on ne représentera dans les figures qui suivent, et donc on ne décrira dans la suite de la description, que le buffer bidirectionnel disposé à gauche de la ligne de transmission AB.

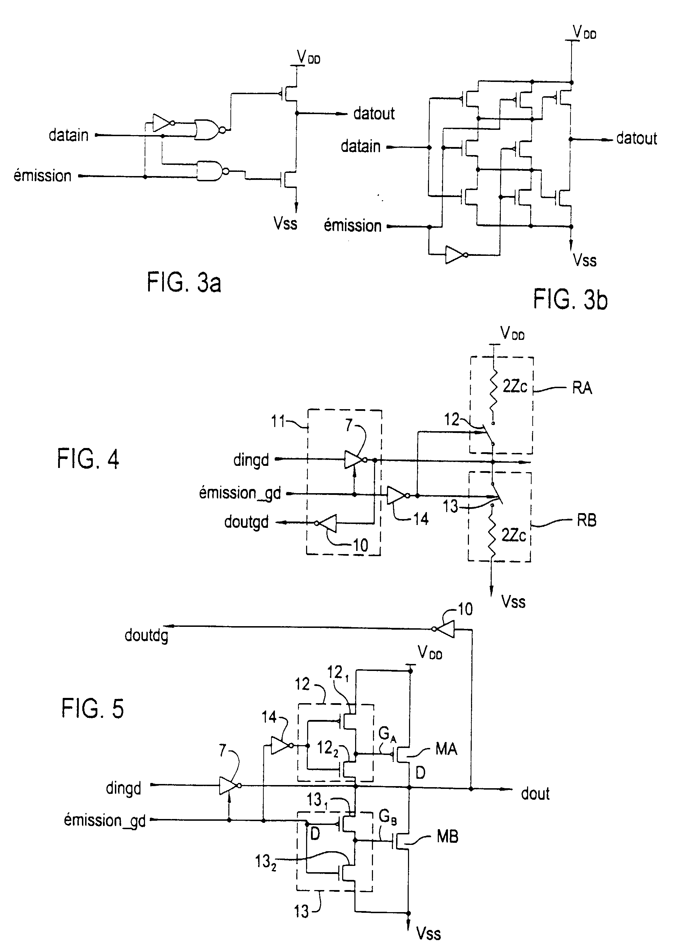

Les figures 3a et 3b illustrent respectivement deux schémas d'amplificateur trois états parmi d'autres schémas possibles. Un amplificateur trois états est nécessaire dans le cas d'une transmission bidirectionnelle telle que celle illustrée à la figure 2 et permet d'inverser le sens de transmission.

L'amplificateur de la figure 3b utilise moins de transistors que celui de la figure 3a (6 au lieu de 8) tout en conservant des caractéristiques électriques similaires.

Une première conséquence néfaste liée à la configuration de la figure 2 est une consommation en courant doublée, toutes les impédances étant divisées par deux.

Une deuxième conséquence néfaste est que, étant donné que du côté émetteur la liaison n'est plus adaptée, en effet on a $Z_C/2$ en parallèle avec $Z_C$ soit $Z_C/3$, le coefficient de réflexion ne vaut plus théoriquement 0 même si la ligne est parfaitement adaptée, mais vaut $(Z_C/3 - Z_C) / (Z_C/3 + Z_C)$ soit - 1/2, si bien que la liaison est moins bien protégée contre les réflexions multiples, en cas d'adaptation approximative de la ligne.

L'idée de l'invention consiste à intégrer des résistances d'adaptation sur le circuit intégré lui-même, sous forme de transistors MOS et aptes à être commandés par les signaux de commande validant l'émission ou la réception, de façon à contrôler la mise en oeuvre ou au contraire la mise hors-circuit des résistances d'adaptation. On cherche donc à se ramener au schéma de principe de la figure 1, et ceci quel que soit le sens de transfert des données.

La figure 4 illustre le schéma de principe d'un buffer bidirectionnel 11, délimité par une ligne fermée discontinue, d'une liaison selon l'invention, pour réaliser des liaisons CMOS bidirectionnelles adaptées à la fois en émission et en réception.

L'étage émetteur 7 du buffer bidirectionnel 11 est un amplificateur trois états recevant les données à émettre dingd et le signal de commande émission_gd.

Des résistances commandées $R_A$ et $R_B$, délimitées respectivement par une ligne fermée discontinue, sont montées en interface entre la ligne de transmission et le buffer bidirectionnel 11.

Les résistances commandables $R_A$ et $R_B$ doivent valoir théoriquement respectivement $2Z_C$ et être validées en opposition de phase avec le signal de commande de validation de l'émetteur trois états. Cette validation est obtenue par le signal de commande émission_gd agissant respectivement sur les inverseurs 12 et 13 des résistances commandées $R_A$ et $R_B$. La mise en opposition de phase est symbolisée par un inverseur 14 et couplé à la sortie du buffer bidirectionnel 11.

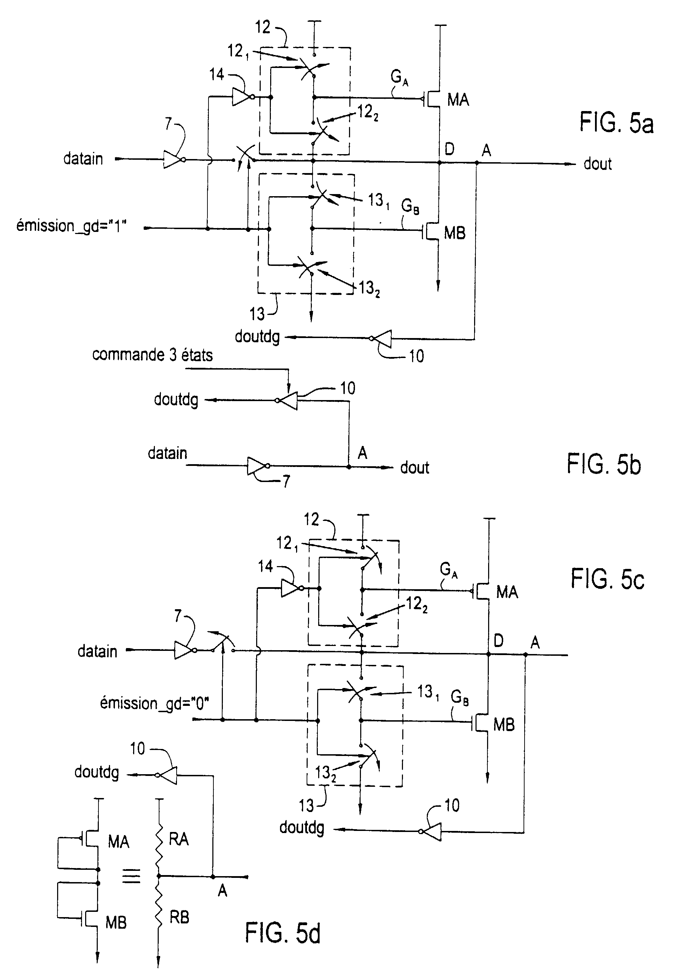

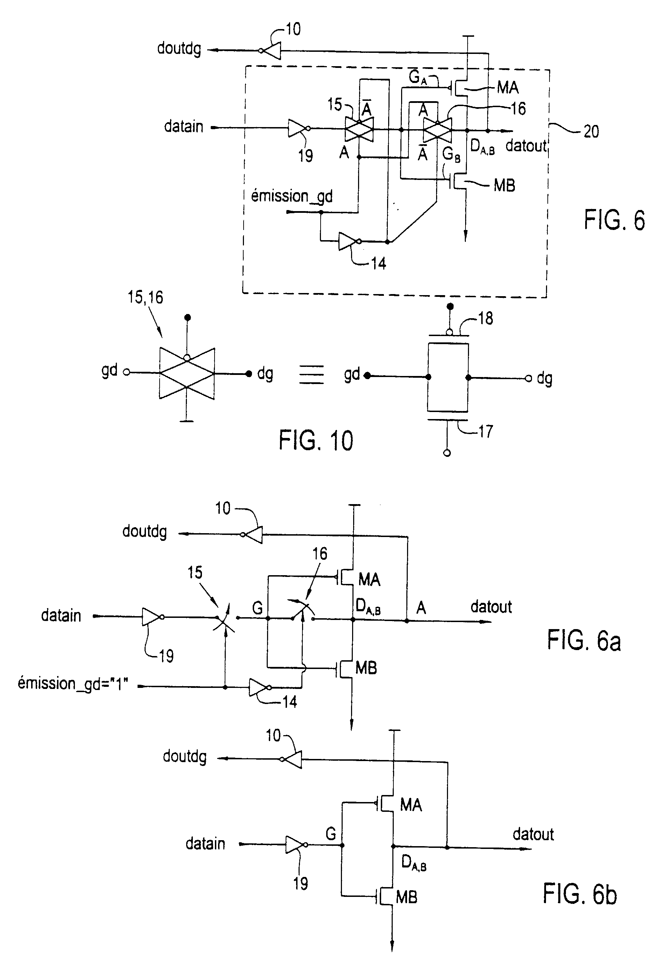

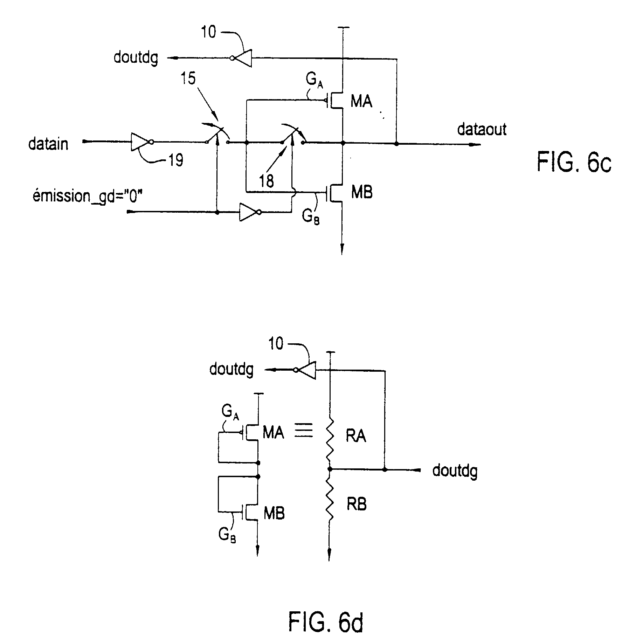

Le fonctionnement d'un buffer CMOS bidirectionnel d'une liaison selon l'invention est maintenant décrit en référence aux schémas électriques des modes de réalisation illustrés aux figures 5 et 6.

La figure 5 illustre un premier mode de réalisation d'un émetteur bidirectionnel d'une liaison selon l'invention, mettant en oeuvre des transistors MOSNP et MOSN, respectivement $M_A$ et $M_B$, destinés à se comporter comme les résistances $R_A$ et $R_B$ du schéma de principe de la figure 4.

Dans ce mode de réalisation, les "résistances" MOS $R_A$ et $R_B$ sont tout à fait distinctes des transistors MOS de l'amplificateur trois états 7.

Le transistor $M_B$ est commandé, via un premier étage de commutation 13 délimité par une ligne fermée discontinue, par le signal de commande émission_gd validant soit le mode émission soit le mode réception et le transistor $M_A$ est commandé, via un deuxième étage de commutation 12 délimité par une ligne fermée discontinue, par le même signal de commande inversé.

L'interrupteur commandé 12 de la figure 4 est réalisé par des transistors MOSP $12_1$ et MOSN $12_2$ et l'interrupteur commandé 13 par les transistors MOSP $13_1$ et MOSN $13_2$. Les grilles des transistors $12_1$ et $12_2$ reçoivent le signal de commande émission_gd inversé par l'inverseur 14, et les grilles des transistors $13_1$ et $13_2$ reçoivent directement ce même signal.

La figure 5a illustre de façon schématique le comportement des transistors $12_1$, $12_2$, $13_1$ et $13_2$ en régime de commutation dans le cas où le signal de commande émission_gd vaut un "1" logique, c'est-à-dire quand on est dans le mode émission.

Dans le mode émission, les transistors $12_1$ et $13_2$ se comportent comme des interrupteurs fermés, et les transistors $12_2$ et $13_1$ se comportent comme des interrupteurs ouverts. La grille du transistor Ma reçoit alors un "1" logique et la grille du transistor $M_B$ un "0" logique ce qui revient à déconnecter les "résistances" $M_A$ et $M_B$ de la ligne de transmission AB.

Le premier étage de commutation 13, délimité par une ligne fermée discontinue, se comporte comme deux interrupteurs complémentaires $13_1$ et $13_2$, en série entre eux et avec le potentiel d'alimentation basse $V_{SS}$ et la sortie de l'amplificateur trois états 7.

Le point commun des deux interrupteurs $13_1$ et $13_2$ est couplé à la grille $G_B$ du transistor $M_B$, et connecte la grille $G_B$ soit au potentiel d'alimentation basse $V_{SS}$ en émission, le transistor $M_B$ étant alors hors circuit, soit au point A (drain du transistor $M_B$), le transistor $M_B$ se comportant comme une résistance $R_B$.

Le deuxième étage de commutation 12, délimité par une ligne fermée discontinue, se comporte comme deux interrupteurs complémentaires $12_1$ et $12_2$, en série entre eux et avec le potentiel d'alimentation haute Vdd et la sortie le l'amplificateur trois états 7.

Le point commun des deux interrupteurs $12_1$ et $12_2$ est couplé à la grille $G_A$ du transistor $M_A$, et connecte la grille $G_A$ soit au potentiel d'alimentation haute $V_{DD}$ en émission, le transistor $M_A$ étant alors hors circuit, soit au point A (drain du transistor $M_A$), le transistor $M_A$ se comportant comme une résistance RA.

Le schéma équivalent du buffer bidirectionnel en émission se réduit ainsi au schéma de la figure 5b, et comporte le buffer émission 7 qui est actif et le buffer réception 10 qui est dans ce cas un amplificateur trois états commandé pour être dans l'état haute impédance ; la sortie du buffer émission 7 et l'entrée du buffer réception 10 étant respectivement connectées à l'extrémité A de la ligne de transmission AB non représentée.

La figure 5c illustre le comportement de ces mêmes transistors quand le signal de commande émission_gd vaut un "0" logique, c'est-à-dire quand on est dans le mode réception.

Dans le mode réception, les transistors $12_1$ et $13_2$ se comportent comme des interrupteurs ouverts, et les transistors $12_2$ et $13_1$ se comportent comme des interrupteurs fermés. Les grilles $G_A$ et $G_B$ des transistors $M_A$ et $M_B$ sont alors directement branchées à la ligne de transmission AB, non représentée, et les transistors $M_A$ et $M_B$ se comportent alors comme des résistances de valeur respective $2Z_C$ et constituent ainsi les résistances d'adaptation sur la ligne de transmission AB.

Le signal de commande de l'amplificateur trois états 7 étant au niveau logique "0" en réception, l'émetteur trois états est dans l'état haute impédance et n'intervient donc plus dans le schéma équivalent du buffer bidirectionnel selon l'invention, en réception.

Le schéma de la figure 5c se réduit ainsi au schéma de la figure 5d, et comporte le buffer réception 14 qui est actif et les résistances d'adaptation correspondant respectivement aux transistors $M_A$ et $M_B$, connectés au point A de la ligne de transmission AB.

La figure 6 illustre un deuxième mode de réalisation d'un buffer bidirectionnel, dans lequel les mêmes transistors $M_A$ et $M_B$ sont utilisés à la fois pour l'émission et comme résistances d'adaptation en réception.

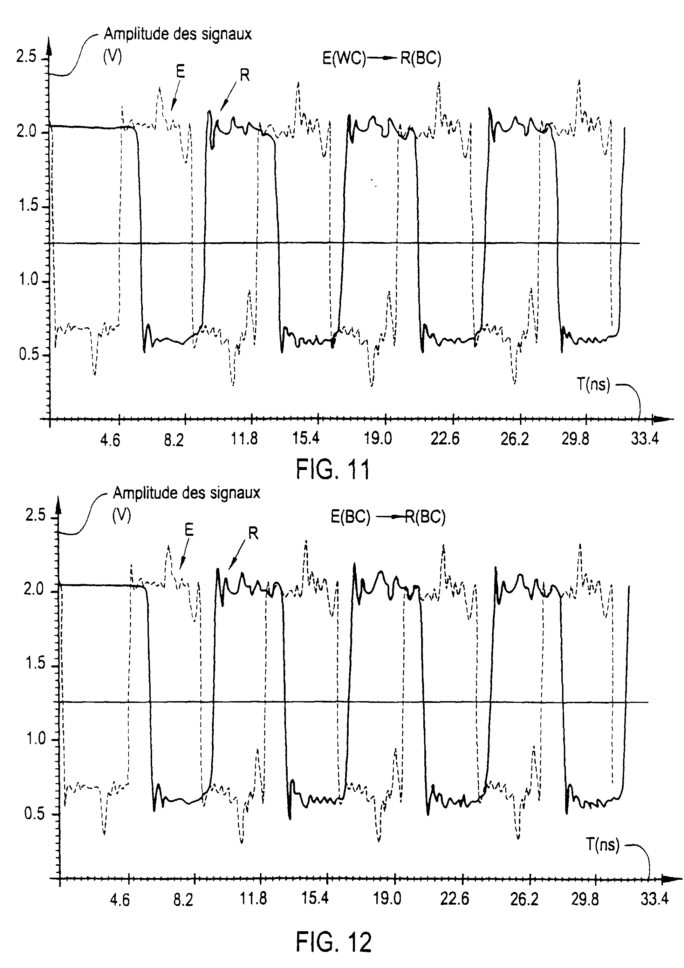

Dans ce mode de réalisation, on utilise deux étages de commutation CMOS 15 et 16 dont le schéma équivalent est illustré à la figure 10.

Les étages de commutation 15 et 16, comportent respectivement un transistor MOSN 17 et un transistor MOSP 18 montés en parallèle comme illustré à la figure 10. Les grilles des transistors 17 et 18 recevant respectivement le signal de commande et le signal de commande complémentaire, et les bornes d'entrée-sortie des données correspondant respectivement aux points communs gd et dg des deux transistors 17 et 18.

Si une tension positive est appliquée sur la borne gd et une tension négative est appliquée sur la borne dg de l'étage de commutation 15 ou 16, alors la source du transistor 17 sera du côté de la borne dg.

Un tel montage permet d'optimiser la conduction ou la non conduction du MOSN 17 et du MOSP 18 dans les deux sens de passage du courant à travers l'interrupteur 15 ou 16. On réalise ainsi un interrupteur presque parfait. Il faut également que les signaux de commande arrivant respectivement sur les grilles des MOSN 17 et du MOSP 18 soient en opposition de phase.

L'étage émetteur comporte un amplificateur 19 recevant les données à émettre datain, un premier étage de commutation 15 couplé en série, en sortie de l'amplificateur 19 et commandé par le signal de commande émission_gd, et un deuxième étage de commutation 16 couplé en série, en sortie du premier étage de commutation 15, commandé par le même signal de commande inversé.

Les transistors $M_A$ et $M_B$ sont montés en sortie des étages de commutation 15 et 16 et en entrée de l'étage récepteur 10, les grilles $G_A$ et $G_B$ des transistors $M_A$ et $M_B$ étant communes et couplées d'une part à la sortie de l'amplificateur 19 via le premier étage de commutation 15, et couplées d'autre part aux drains $D_{A,B}$ des transistors $M_A$ et $M_B$ via le deuxième étage de commutation 16.

Le premier et le deuxième étages de commutation 15 et 16 se comportent comme des interrupteurs complémentaires qui, en émission, connectent les grilles $G_A$ et Gb à la sortie de l'amplificateur 19 et déconnectent les grilles des drains. Les transistors $M_A$ et $M_B$ se comportent alors comme un amplificateur CMOS.

Les interrupteurs 15 et 16, en réception, connectent les drains aux grilles et déconnectent les grilles de la sortie de l'amplificateur 19. Les transistors se comportent alors comme des résistances $R_A$ et $R_B$.

L'ensemble comportant l'amplificateur 19, les étages de commutation 15 et 16, l'inverseur 14 et les transistors $M_A$ et $M_B$, définit un étage émetteur 20 d'une liaison selon l'invention. Cet étage émetteur 20 est délimité par une ligne fermée discontinue.

La figure 6a illustre de façon schématique le comportement des interrupteurs CMOS 15 et 16 dans le cas où le signal de commande émission_gd = "1" logique, c'est-à-dire quand on est dans le mode émission.

A l'émission, le transistor MOSN du premier interrupteur 15 reçoit un "1" logique sur sa grille et le transistor MOSP du deuxième interrupteur 16 reçoit un "1" logique sur sa grille, et quasi simultanément, le transistor MOSP du premier interrupteur 15 reçoit un "0" logique sur sa grille et le transistor MOSN du deuxième interrupteur 16 reçoit un "0" logique sur sa grille.

Le schéma de la figure 6b illustre le schéma équivalent obtenu en émission, c'est-à-dire quand le premier interrupteur 15 est fermé et le deuxième interrupteur 16 est ouvert. Les transistors $M_A$ et $M_B$ sont montés en émetteur en série avec le buffer émetteur 19 recevant les données datain.

La figure 6c illustre de façon schématique le comportement des interrupteurs CMOS 15 et 16 dans le cas où le signal de commande émission_gd = "0" logique, c'est-à-dire quand on est dans le mode réception.

Le transistor MOSN du premier interrupteur 15 reçoit un "0" logique sur sa grille et le transistor MOSP du deuxième interrupteur 16 reçoit un "0" logique sur sa grille, et quasi simultanément, le transistor MOSP du premier interrupteur 15 reçoit un "1" logique sur sa grille et le transistor MOSN du deuxième interrupteur 16 reçoit un "1" logique sur sa grille.

Le schéma de la figure 6d illustre le schéma équivalent obtenu en réception, c'est-à-dire quand le premier interrupteur 15 est ouvert et le deuxième interrupteur 16 est fermé. Les transistors $M_A$ et $M_B$ se comportent en résistances d'adaptation $R_A$ et $R_B$ sur l'extrémité de la ligne de transmission recevant les données doutdg, en entrée du buffer de réception 10.

Les conditions de polarisation sont différentes suivant l'état logique "1" ou "0" des entrées/sorties, à l'émission et à la réception. A l'émission, les tensions de polarisation des grilles $G_A$ et $G_B$ des transistors $M_A$ et $M_B$ sont égales à $V_{DD}$ ou $V_{SS}$. A la réception, la polarisation des grilles des transistors est égale à $3V_{DD}/4$ ou $V_{DD}/4$.

La valeur des résistances sera donc un peu plus élevée pour la réception que pour l'émission

Il y a aussi la mise en parallèle partielle des résistances effectives des transistors MOSN et MOSP dont il faut tenir compte et qui aurait tendance à agir dans le sens contraire ; le transistor MOSN étant surtout efficace au niveau haut et le transistor MOSP au niveau bas. Cet effet étant cependant peu sensible, l'ensemble des considérations précédentes fera que le critère CNOP, dans le sens précédemment défini, sera automatiquement rempli.

Dans ce mode de réalisation, les transistors $M_A$ et $M_B$ qui sont utilisés comme résistances d'adaptation et participent également à l'émission du signal datain, ce qui permet d'utiliser moins de transistors par rapport au premier mode de réalisation, illustré à la figure 5, et de choisir comme buffer émetteur 19 des transistors "petits" en dimension. Ce mode de réalisation apporte donc un avantage supplémentaire en terme de place par rapport au premier mode de réalisation pour lequel le buffer émetteur trois états 7, participait seul à l'émission proprement dite et où les transistors $M_A$ et $M_B$ intervenaient uniquement en mode réception.

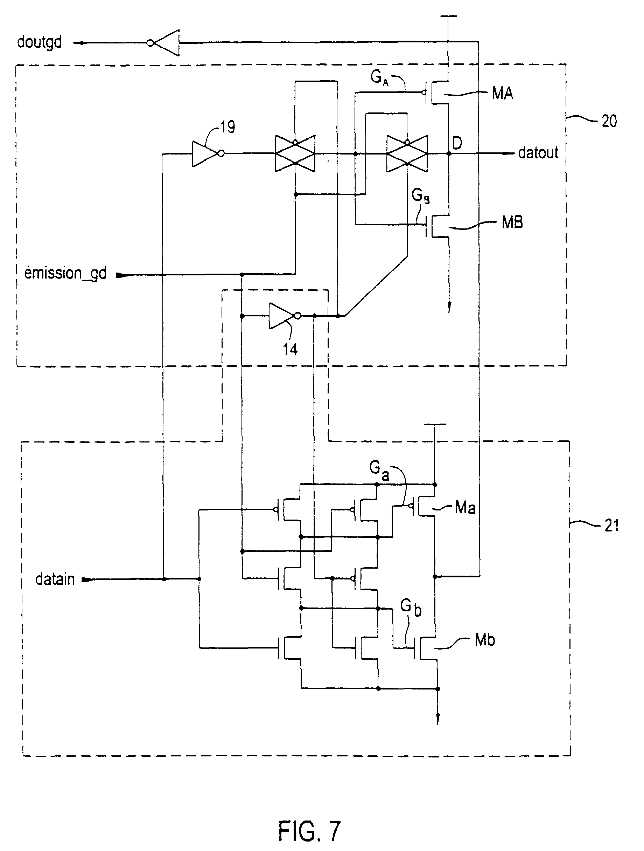

La figure 7 illustre une première variante du buffer bidirectionnel d'une liaison selon l'invention et dans laquelle sa résistance équivalente à l'émission peut être rendue plus faible indépendamment de sa résistance équivalente à la réception.

Dans cette première variante, le buffer bidirectionnel comporte un premier étage émetteur principal 20 correspondant à l'étage émetteur, illustré à la figure 6, et un deuxième étage 21 correspondant à l'émetteur trois états illustré à la figure 3b. Ces deux étages 20 et 21 sont délimités respectivement par une ligne fermée discontinue.

Le deuxième étage 21 est monté en parallèle sur le premier étage 20 entre l'entrée recevant les données datain, et la sortie délivrant les données dataout.

Ils ont en commun l'inverseur 14 et reçoivent sur leurs entrées respectives le signal de commande émission_gd et les données à transmettre datain.

Dans le cas où un ajustement de 10 ou 20% de la résistance équivalente est nécessaire, seuls les transistors $M_A$ et $M_B$ sont "gros" du point de vue dimensionnel; les transistors Ma et Mb servant juste à donner un complément de conductance gardent une taille en proportion relativement modeste.

En émission, les transistors $M_A$ et $M_B$ conduisent simultanément et leurs résistances équivalente se retrouvent en parallèle. La taille du transistor Ma étant plus réduite que le transistor $M_A$, sa résistance équivalente est donc plus forte que celle du transistor $M_A$ de façon à apporter la correction de 10 à 20 % citée précédemment. La mise en parallèle a pour effet d'abaisser la valeur de la résistance équivalente globale.

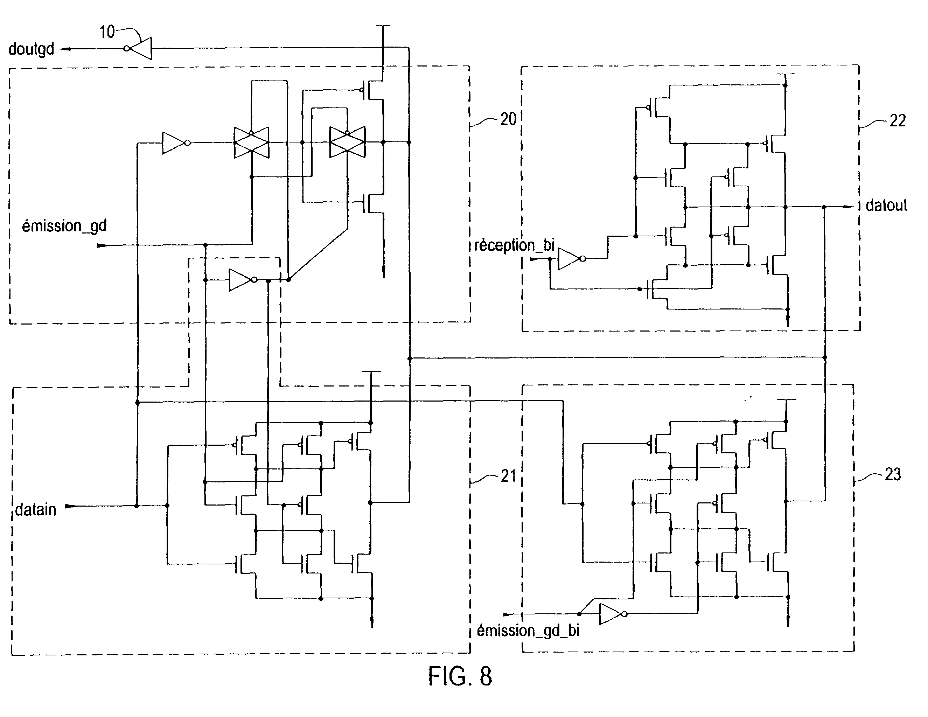

La figure 8 illustre une deuxième variante d'un buffer bidirectionnel d'une liaison selon l'invention, permettant un réglage supplémentaire, indépendant à la réception et à l'émission pour corriger par exemple des dispersions technologiques trop élevées.

Un troisième étage 22 et un quatrième étage 23 sont ajoutés aux étages 20 et 21 de la première variante. Les étages 20, 21, 22, et 23 sont délimités respectivement par une ligne fermée discontinue.

Le troisième étage 22 est un étage récepteur couplé en sortie de l'étage 20, commandé sur son entrée par un signal de commande de réception reception_bi, et comportant des transistors MOS agencés et dimensionnés pour fournir un complément de conductance en réception indépendamment de l'émission. Sa sortie est couplée sur la sortie commune aux trois autres étages 20, 21 et 22 relatif à l'émission.

Dans cet étage 22, et suivant un comportement déjà décrit, on retrouve la fonction de deux interrupteurs qui dans le mode réception, sont dans l'état passant et transforment les transistors MOSN et MOSP de sortie en résistances d'adaptation.

Deux autres interrupteurs qui dans le mode émission sont dans l'état bloquant, mettent les grilles des transistors de sortie MOSN et MOSP respectivement à $V_{SS}$ et $V_{DD}$, ce qui a pour effet de les mettre en mode haute impédance.

Le quatrième étage 23, correspondant à un troisième étage émetteur, est monté en parallèle sur les premier et deuxième étages 20 et 21. Il reçoit sur une première entrée les données datain et sur une deuxième entrée un deuxième signal de commande émission_gd_bi et comporte des transistors MOS agencés et dimensionnés pour affiner le réglage de la résistance équivalente à l'émission. Le schéma électrique du module 23 correspond à celui du transistor trois états de la figure 3b.

Si on n'utilise que les étages 20 et 22 seuls, on peut réaliser un buffer bidirectionnel qui a les mêmes valeurs de résistance équivalente à l'émission et à la réception car l'étage 22 fournit le complément de conductance qui manque pour la réception.

En multipliant les étages 22 et 23 en parallèle, on augmente les possibilités de réglage. Ces réglages sont mis en oeuvre en positionnant les divers signaux de commande réception_bi et/ou émission_gd_bi en fonction des réglages souhaités en mode réception ou émission.

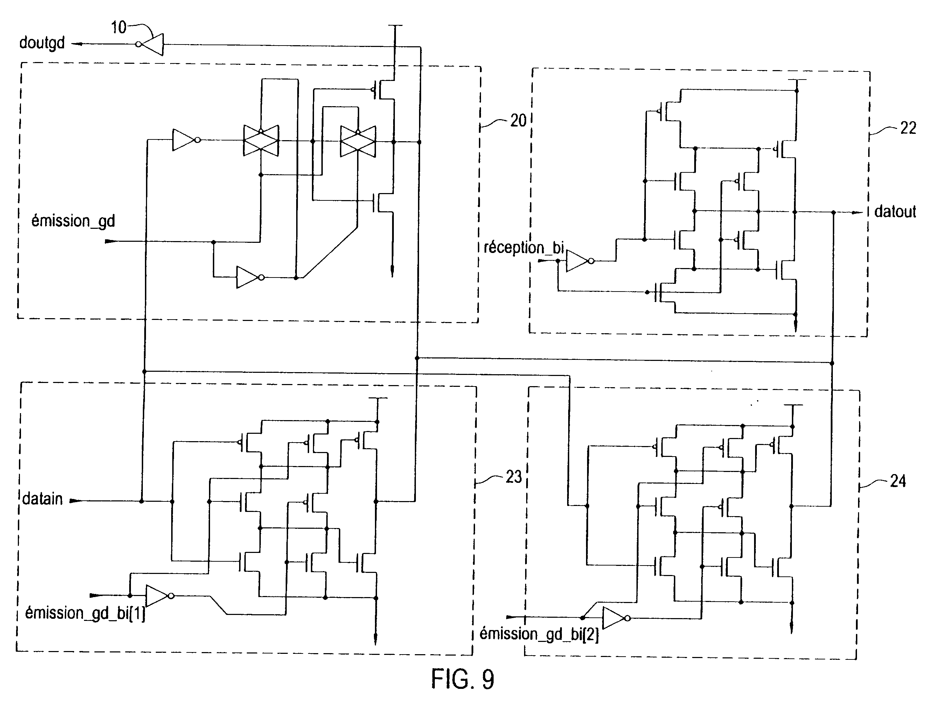

La figure 9 illustre une troisième variante d'un buffer bidirectionnel d'une liaison selon l'invention.

Dans cette troisième variante, les étages 23 et 24 d'architecture similaire reçoivent respectivement un signal de commande émission_bi[2] et émission_bi[1], distincts du signal de commande émission_gd du premier étage 20. Les étages 20, 22, 23, et 24 sont délimités respectivement par une ligne fermée discontinue.

Le deuxième étage émetteur 23 et le troisième étage émetteur 24 sont montés respectivement en parallèle sur le premier étage émetteur 20, et reçoivent respectivement sur leurs premières entrées, les données datain à émettre et respectivement sur leurs deuxièmes entrées le deuxième signal émission_gd_bi [2] et le troisième signal de commande d'émission émission_gd_bi[1].

Ils comportent chacun des transistors MOS agencés et dimensionnés pour affiner le réglage de la résistance équivalente en émission indépendamment de la réception.

En fonction des dispersions technologiques des lots de transistors MOS et des désadaptations vérifiant le critère CNOP énoncé précédemment, on peut définir des plages de valeurs pour les résistances d'adaptation à l'émission et en réception.

Les fabriquants de circuits intégrés, ou puces, appelés également fondeurs, garantissent des caractéristiques rentrant dans une fourchette dite de bon fonctionnement bornée par une limite supérieure et une limite inférieure.

La limite supérieure correspond à des courants débités les plus élevés et donc à des puces les plus rapides. Ces puces sont alors rangées dans une classe technologique appelée BC, abréviations anglo-saxonnes pour "Best Case".

La limite inférieure correspond à des courants débités les plus faibles et donc à des puces les plus lentes. Ces puces sont alors rangées dans une classe technologique appelée WC, abréviations anglo-saxonnes pour "Worst Case".

On vise, de préférence, des valeurs de résistances équivalentes en réception égales à $2Z_C$ de façon à avoir une résistance de Thévenin équivalente égale à $Z_C$ quand on est dans une technologie BC.

Dans le cas général, on aura donc une résistance équivalente en réception plutôt plus grande que $Z_C$.

On vise également, de préférence, des valeurs des résistances équivalentes en émission égales à $Z_C$ quand on est dans une technologie WC.

Dans le cas général, on aura donc une résistance équivalente en émission plutôt plus petite que $Z_C$.

Avec les plages de valeurs définies ci-dessus pour les résistances équivalentes en émission et en réception, on vérifie toujours le critère CNOP cité plus haut.

Parmi les quatre combinaisons suivantes :

a) émetteur WC / récepteur BC ;
b) émetteur BC / récepteur BC ;
c) émetteur WC / récepteur WC ;
d) émetteur BC / récepteur WC ;

les trois combinaisons a), b), et c) donnent un taux de réflexion = 0 après un aller - retour des signaux sur la ligne et une amplitude des signaux transmis $\geq V_{DD}/2$

Dans le cas a), l'amplitude des signaux transmis est égale à $V_{DD}/2$. C'est l'amplitude la plus faible des quatre cas mais les deux coefficients de réflexion sont nuls et on obtient ainsi la meilleure protection contre le bruit.

Dans le cas b), l'amplitude des signaux en émission s'exprime par la formule suivante :

$$V_{amplitude} = V_{DD} \; \frac{Z_C}{R_T + Z_C} \qquad (3)$$

avec $R_T < Z_C$ et donc $V_{amplitude} > V_{DD}/2$.

Le coefficient de réflexion est alors nul du côté réception.

Dans le cas c), on applique la formule (1) au niveau de la réception :

$$C_{reflex} = (R_T - Z_C) / (R_T + Z_C) \qquad (4)$$

avec $R_T > Z_C$, ce qui donne une amplitude totale de :

$$V_{DD}/2 \; (1 + C_{reflex}) > V_{DD}/2 \qquad (5)$$

Le coefficient de réflexion est alors nul du côté émission.

Dans le cas d), la combinaison émetteur BC / récepteur WC aboutit à un certain taux non nul de réflexion aller - retour des signaux mais dans ce cas l'amplitude des signaux est la plus grande du toutes les combinaisons (> $V_{DD}/2$) et est donc la plus à même de supporter un certain taux de réflexion.

Ce centrage de valeurs dès la conception peut éviter tout réglage technologique ultérieur si les dispersions de technologies garanties par le fondeur ne sont pas trop élevées.

on donne ci-après un exemple de dimensionnement dans la technologie 0,25 µ d'un buffer CMOS bidirectionnel avec résistance d'adaptation incorporée au circuit intégré, selon l'invention conforme au deuxième mode de réalisation illustré à la figure 7, pour attaquer une ligne 50 Ohms.

On définit généralement la taille physique d'un transistor par la longueur de sa grille qui doit être la plus faible possible pour limiter le trajet du courant traversant le transistor, et par la largeur de sa source W exprimée en nombre entier d'unité de longueur appelée "Lambda".

Cette unité correspond à une réalité physique liée à la technologie de gravure et correspond en fait à une dimension minimale pouvant être gravée sur le silicium. Dans l'exemple traité, Lambda = 0,25 µm.

A titre d'exemple, une simulation donne les résultats suivants :

Soit WA et WB les largeurs respectives des transistors $M_A$ et $M_B$, Wa et Wb les largeurs respectives des transistors Ma et Mb :

$W_A$ = 244 Lambdas ;
$W_B$ = 103 Lambdas ;
Wa = 79 Lambdas ;
Wb = 27 Lambdas.

Les transistors Ma et Mb sont donc "petits" devant les transistors $M_A$ et $M_B$.

En émission, le signal de commande émission_gd = $V_{DD}$, la dimension du transistor MOSP équivalent vaut : WP = $W_B$ + Wb, et la dimension du transistor MOSN équivalent vaut : WN = $W_A$ + Wa.

En réception, le signal de commande émission_gd = $V_{SS}$, la dimension du transistor MOSP équivalent vaut : WP = $W_B$ et la dimension du transistor MOSN vaut : WN = $W_A$.

On a donc en émission une résistance terminale $R_T < Z_C$ et en réception une résistance terminale $R_T > Z_C$.

Les figures 11 à 14 donnent respectivement sous forme de courbes tension en fonction du temps de propagation, les résultats des simulations effectuées à partir du dimensionnement précédent pour l'émission d'un train d'impulsions dans un cas réel, c'est-à-dire en tenant compte des imperfections de la ligne de transmission.

Ces imperfections sont notamment dues au câblage des puces dans leurs boîtiers, au câblage interne des boîtiers, à la soudure des boîtiers sur le circuit imprimé, qui provoquent des ruptures d'impédance.

Sur ces courbes, le signal reçu à l'entrée du récepteur après transmission sur la ligne, est représenté en trait plein et le signal de sortie de l'émetteur en pointillés. Le signal à l'entrée de l'émetteur n'est pas représenté.

La figure 11 illustre le cas a) où l'émetteur est WC et le récepteur BC.

La figure 12 illustre le cas b) où l'émetteur est BC et le récepteur BC.

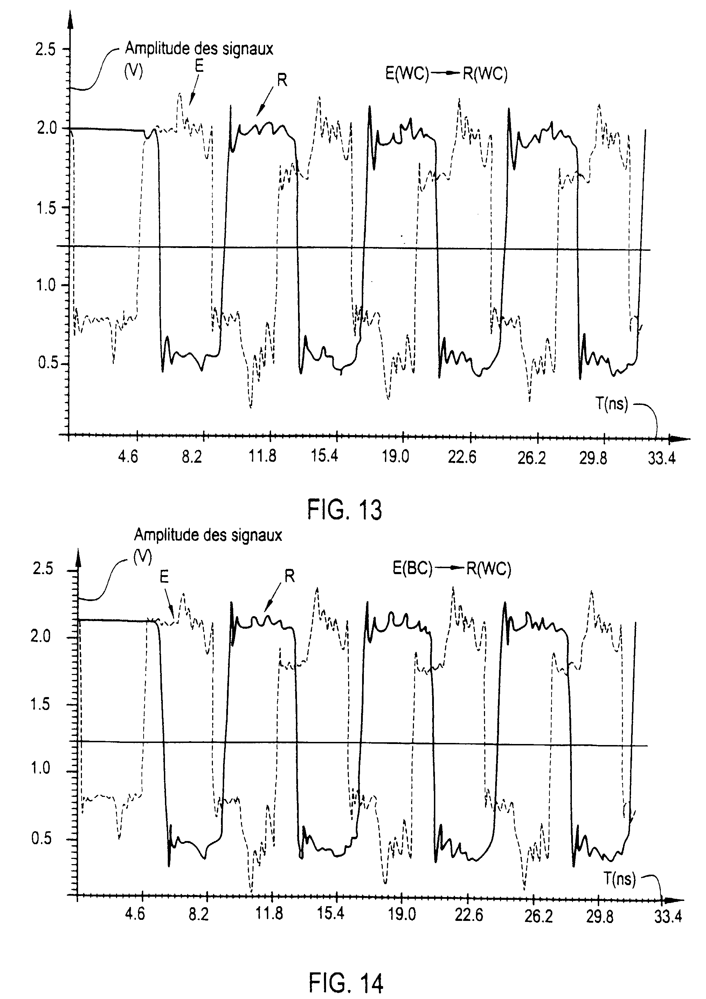

La figure 13 illustre le cas c) où l'émetteur est WC et le récepteur WC.

La figure 14 illustre le cas d) où l'émetteur est BC et le récepteur WC.

Enfin, la figure 15, illustre le diagramme, en émission et en réception, du courant I en fonction de la tension V des transistors MOSN et MOSP agencés en résistances d'adaptation dont le schéma est représenté à la figure 16.

Ce diagramme illustre par une résolution graphique le dimensionnement des transistors MOSN et MOSP.

On a représenté en trait plein les caractéristiques du MOSN et du MOSP en mode réception et en trait mixte les caractéristiques du MOSN et du MOSP en mode émission.

Comme décrit précédemment, les résistances $R_A$ et $R_B$ doivent avoir pour valeur théorique respective 2ZC.

C'est théoriquement vrai si les caractéristiques des résistances $R_A$ et $R_B$ sont linéaires. Dans la réalité elles ne le sont pas. La somme algébrique des caractéristiques est par contre quasiment linéaire.

La droite $\Delta$ a une pente égale à l'impédance caractéristique $Z_C$ = 50 Ohms. Les transistors MOSN et MOSP sont dimensionnés et appairés pour que la somme algébrique de leurs caractéristiques en réception coïncide avec la droite $\Delta$ et pour que leurs caractéristiques en émission coupent respectivement la droite $\Delta$ aux points d'intersection E1 et E2, appelés points de repos, pour lesquels les MOSN et MOSP débitent respectivement le même courant et ont la même tension appliquée, $V_{DD}/4$ pour E2 et $3V_{DD}/4$ pour E1 sur la figure.

La caractéristique en réception du transistor MOSN tangente l'axe des abscisses au point $V_{TN}$ qui correspond à la tension de seuil du transistor MOSN, et la caractéristique en réception du transistor MOSP tangente l'axe des abscisses au point $V_{DD} - V_{TP}$ qui correspond à la tension de seuil du transistor MOSP.

Le dimensionnement des transistors MOSN et MOSP revient donc à positionner les points de repos sur la droite $\Delta$ en fonction du niveau des tensions d'alimentation.

Le fait que les caractéristiques de chaque résistance $R_A$ et $R_B$ décrivent des courbes de nature parabolique et non pas linéaire, est plutôt un avantage en ce sens qu'elles permettent des réglages des point de repos E1 et E2 par des dimensionnements pratiquement indépendants des tailles des transistors MOSN et MOSP de réception.

L'adaptation est parfaite quand la droite $\Delta$ joignant E1 et E2 a une pente $\Delta V/\Delta I$ égale à $Z_C$.

## Revendications

1. Liaison CMOS bidirectionnelle bipoint du type comportant une ligne de transmission (AB) adaptée reliant respectivement à ses deux extrémités deux circuits intégrés comportant respectivement un dispositif émetteur-récepteur comportant un étage émetteur (7 ; 20) et un étage récepteur (10), en interface sur la ligne et commandé pour émettre ou recevoir des données numériques échangées sur la ligne de transmission (AB) en fonction d'un signal de commande (émission_gd) pour être soit en mode émission, soit en mode réception, les dispositifs émetteur-récepteur n'étant jamais simultanément dans le même mode, caractérisée en ce que chaque dispositif émetteur-récepteur comporte au moins un transistor MOSP ($M_A$) et un transistor MOSN ($M_B$), dimensionnés, agencés et commandés en opposition de phase avec le signal de commande pour se comporter comme des résistances d'adaptation ($R_A$ et $R_B$) adaptant la liaison (AB) aux deux extrémités de la ligne de transmission (AB).

2. Liaison selon la revendication 1, caractérisée en ce que les résistances d'adaptation ($R_A$) et ($R_B$) ont des caractéristiques paraboliques et en ce que leur somme algébrique définit une caractéristique quasi linéaire ($\Delta$) dont la pente ($\Delta V/\Delta I$) est sensiblement égale à la valeur de l'impédance caractéristique

($Z_C$) de la ligne de transmission (AB).

3. Liaison selon l'une quelconque des revendications 1 à 2, caractérisée en ce que l'étage émetteur (7) du dispositif émetteur-récepteur (11) est un amplificateur trois états recevant les données à émettre et le signal de commande, et en ce que les transistors MOSP ($M_A$) et MOSN ($M_B$) sont montés en sortie de l'amplificateur trois états et en entrée de l'étage récepteur (10) du dispositif émetteur-récepteur (11), le transistor MOSN ($M_B$) étant commandé via un premier étage de commutation (13) par le signal de commande validant soit le mode émission soit le mode réception et le transistor MOSP ($M_A$) étant commandé via un deuxième étage de commutation (12) par le même signal de commande inversé.

4. Liaison selon la revendication 3, caractérisée en ce que le premier étage de commutation (13) se comporte comme deux interrupteurs complémentaires ($13_1$ et $13_2$), en série entre eux et avec le potentiel d'alimentation basse ($V_{SS}$) et la sortie de l'amplificateur trois états (7) ; le point commun des deux interrupteurs ($13_1$ et $13_2$), étant couplé à la grille ($G_B$) du transistor MOSN ($M_B$), et connecte la grille soit au potentiel d'alimentation basse en émission, le transistor MOSN ($M_B$) étant alors hors circuit, soit au potentiel d'alimentation haute ($V_{DD}$) en réception, le transistor MOSN ($M_B$) se comportant comme une résistance d'adaptation ($R_B$), et en ce que le deuxième étage de commutation (12) se comporte comme deux interrupteurs complémentaires ($12_1$ et $12_2$), en série entre eux et avec le potentiel d'alimentation haute ($V_{DD}$) et la sortie de l'amplificateur trois états (7), le point commun des deux interrupteurs ($12_1$ et $12_2$) étant couplé à la grille ($G_A$) du transistor MOSP ($M_A$), et connecte la grille ($G_A$) soit au potentiel d'alimentation haute ($V_{DD}$) en émission, le transistor MOSP ($M_A$) étant alors hors circuit, soit au potentiel d'alimentation basse ($V_{SS}$), le transistor MOSP ($M_A$) se comportant comme une résistance d'adaptation ($R_A$).

5. Liaison selon l'une quelconque des revendications 1 à 2, caractérisée en ce qu'un premier étage émetteur (20) comporte un amplificateur (19) recevant les données à émettre (datain), un premier étage de commutation (15) couplé en série, en sortie de l'amplificateur (19) et commandé par le signal de commande, et un deuxième étage de commutation (16) couplé en série, en sortie du premier étage de commutation (15), commandé par le signal de commande inversé, et en ce que les transistors MOSP ($M_A$) et MOSN ($M_B$) sont montés en sortie des étages de commutation (15 et 16) et en entrée de l'étage récepteur (10), les grilles des transistors ($M_A$ et $M_B$) étant communes et couplées d'une part à la sortie de l'amplificateur via le premier étage de commutation (15), et couplées d'autre part aux drains des transistors via le deuxième étage de commutation (16).

6. Liaison selon la revendication 5, caractérisée en ce que le premier et le deuxième étages de commutation (15 et 16) sont des interrupteurs complémentaires qui respectivement, en émission, connectent les grilles ($G_A$ et $G_B$) des transistors MOSP et MOSN ($M_A$ et $M_B$) à la sortie de l'amplificateur (19) et déconnectent les grilles ($G_A$ et $G_B$) des drains ($D_{A,B}$) des transistors MOSP et MOSN ($M_A$ et $M_B$), les transistors MOSP et MOSN ($M_A$ et $M_B$) se comportant comme un amplificateur CMOS, et qui respectivement, en réception, connectent les drains ($D_{A,B}$) aux grilles ($G_A$ et $G_B$) et déconnectent les grilles ($G_A$ et $G_B$) de la sortie de l'amplificateur (19), les transistors MOSP et MOSN ($M_A$ et $M_B$) se comportant respectivement comme des résistances ($R_A$ et $R_B$).

7. Liaison selon l'une quelconque des revendications 5 et 6, caractérisée en ce que les étages de commutation (15 et 16) comportent respectivement un transistor MOSP (18) et un transistor MOSN (17) montés en parallèle, les grilles des transistors (17 et 18) recevant respectivement le signal de commande et le signal de commande complémentaire, et les bornes d'entrée-sortie des données correspondant respectivement aux points communs des deux transistors (17 et 18).

8. Liaison selon l'une quelconque des revendications 5 à 7, caractérisée en ce que les dimensions des transistors MOSP et MOSN ($M_A$ et $M_B$) utilisés pour l'adaptation sont sensiblement du même ordre de grandeur que les dimensions des transistors MOS utilisés pour l'émission et la réception des données.

9. Liaison selon l'une quelconque des revendications 5 à 8, caractérisée en ce qu'elle comporte en outre un deuxième étage émetteur (21), monté en parallèle sur le premier étage émetteur (20) recevant sur une première entrée les données (datain) à émettre et sur une deuxième entrée le signal de commande (émission_gd), et comportant des transistors MOS agencés et dimensionnés pour régler la valeur de la résistance équivalente en émission de la liaison, indépendamment de sa résistance équivalente en réception.

10. Liaison selon la revendication 9, caractérisée en ce qu'elle comporte en outre au moins un étage récepteur (22) couplé en sortie du dispositif émetteur-récepteur (10, 20), commandé sur son entrée par un signal de commande de réception (réception_bi), et comportant des transistors MOS agencés et dimensionnés pour fournir un complément de conductance en réception indépendamment de l'émission.

11. Liaison selon l'une quelconque des revendications 9 et 10, caractérisée en ce qu'elle comporte en outre au moins un troisième étage émetteur (23) monté en parallèle sur les premier et deuxième étages émetteur (20 et 21), recevant sur une première entrée, les données (datain) à émettre et sur une deuxième entrée un deuxième signal de commande d'émission (émission_gd_bi) indépendant du premier, et comportant des transistors MOS agencés et dimensionnés pour affiner le réglage de la résistance équivalente en émission indépendamment de la réception.

12. Liaison selon la revendication 9, caractérisée en ce qu'elle comporte en outre un étage récepteur (22) couplé en sortie du dispositif émetteur-récepteur (10, 20), commandé sur son entrée par un signal de commande de réception (réception_bi), et en ce qu'elle comporte en outre au moins un deuxième étage émetteur (23) et un troisième étage émetteur (24) montés respectivement en parallèle sur le premier étage émetteur (20), recevant respectivement sur leurs premières entrées, les données (datain) à émettre et respectivement sur leurs deuxième entrées un deuxième signal (émission_gd_bi[1]) et un troisième signal (émission_gd_bi[1]) de commande d'émission, et comportant des transistors MOS agencés et dimensionnés pour affiner le réglage de la résistance équivalente en émission indépendamment de la réception.

FIG. 1

FIG. 1a

FIG. 1b

FIG. 2

FIG. 2a

FIG. 3a

FIG. 3b

FIG. 4

FIG. 5

FIG. 5a

FIG. 5b

FIG. 5c

FIG. 5d

doutdg

datain

émission_gd

**FIG. 6**

**FIG. 10**

15,16

gd $\equiv$ dg

**FIG. 6a**

doutdg

datain

émission_gd="1"

**FIG. 6b**

doutdg

datain

datout

doutdg ← 10

datain → 19

émission_gd="0"

15

18

G_A

MA

G_B

MB

dataout

FIG. 6c

doutdg ← 10

G_A

MA

G_B

MB

≡

RA

RB

→ doutdg

FIG. 6d

FIG. 7

FIG. 8

FIG. 9

FIG. 11

FIG. 12

FIG. 13

FIG. 14

$I$

émission MOSP

$E_1$

réception MOSN

$\Delta$

$3V_{DD}/4$

$V$

$V_{TN}$  $V_{DD}/4$

$V_{DD} - V_{TP}$  $V_{DD}$

réception MOSP

$E_2$

émission MOSN

FIG. 15

$V_{DD}$

MA

$I$

$V$

MB

$V_{SS}$

FIG. 16

EP 0 998 082 A1

**Office européen des brevets**

# RAPPORT DE RECHERCHE EUROPEENNE

Numéro de la demande

EP 99 40 2681

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | HYEONGHO LEE ET AL: "A CMOS SERIAL LINK FOR FULLY DUPLEXED DATA COMMUNICATION" IEEE JOURNAL OF SOLID-STATE CIRCUITS, vol. 30, no. 4, 1 avril 1995 (1995-04-01), pages 353-363, XP000506438 ISSN: 0018-9200 * sections III.B, III,D * * figures 5,8,9 * | 1 | H04L25/02 H03K19/00 |
| X | TOSHIRO TAKAHASHI ET AL: "WP 2.5: A CMOS GATE ARRAY WITH 600MB/S SIMULTANEOUS BIDIRECTIONAL I/O CIRCUITS" IEEE INTERNATIONAL SOLID STATE CIRCUITS CONFERENCE, vol. 38, 1 février 1995 (1995-02-01), pages 40-41, XP000557545 ISSN: 0193-6530 * page 40, colonne de gauche, alinéa 4 - colonne de droite, alinéa 2 * * figure 2 * | 1 | |
| X | KNIGHT T F ET AL: "A SELF-TERMINATING LOW-VOLTAGE SWING CMOS OUTPUT DRIVER" IEEE JOURNAL OF SOLID-STATE CIRCUITS, vol. 23, no. 2, 1 avril 1988 (1988-04-01), pages 457-464, XP002031275 ISSN: 0018-9200 * section IV * * figures * | 1 | DOMAINES TECHNIQUES RECHERCHES (Int.Cl.7) H04L H03K |
| X | US 5 514 983 A (YOSHINO RYOZO) 7 mai 1996 (1996-05-07) * colonne 1, ligne 41 - colonne 3, ligne 31 * * figures * | 1 | |

-/--

Le présent rapport a été établi pour toutes les revendications

| Lieu de la recherche | Date d'achèvement de la recherche | Examinateur |
|---|---|---|
| LA HAYE | 14 février 2000 | De Riccardis, F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**Office européen des brevets**

**RAPPORT DE RECHERCHE EUROPEENNE**

Numéro de la demande

EP 99 40 2681

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 5 675 584 A (JEONG DEOG-KYOON) 7 octobre 1997 (1997-10-07) * colonne 11, ligne 11 - colonne 12, ligne 35 * * figure 9 * | 1 | |
| A | US 5 578 939 A (BEERS GREGORY E ET AL) 26 novembre 1996 (1996-11-26) * colonne 2, ligne 33 - colonne 3, ligne 13 * * figures * | 1 | |
| A | EP 0 620 649 A (AT & T GLOBAL INF SOLUTION) 19 octobre 1994 (1994-10-19) * abrégé * * figures 1,2,7 * | 1 | |
| A | US 5 760 601 A (FRANKENY RICHARD FRANCIS) 2 juin 1998 (1998-06-02) * abrégé * | 1 | |

DOMAINES TECHNIQUES RECHERCHES (Int.Cl.7)

Le présent rapport a été établi pour toutes les revendications

| Lieu de la recherche | Date d'achèvement de la recherche | Examinateur |
|---|---|---|
| LA HAYE | 14 février 2000 | De Riccardis, F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 99 40 2681

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-02-2000

| Document brevet cité au rapport de recherche | | Date de publication | Membre(s) de la famille de brevet(s) | | Date de publication |
|---|---|---|---|---|---|
| US 5514983 | A | 07-05-1996 | JP | 7202675 A | 04-08-1995 |
| | | | KR | 9707987 B | 19-05-1997 |
| US 5675584 | A | 07-10-1997 | US | 5714904 A | 03-02-1998 |
| | | | EP | 0686920 A | 13-12-1995 |
| | | | JP | 8056240 A | 27-02-1996 |
| | | | US | 5705947 A | 06-01-1998 |
| | | | US | 5587709 A | 24-12-1996 |
| | | | US | 5712585 A | 27-01-1998 |
| | | | US | 5802103 A | 01-09-1998 |
| US 5578939 | A | 26-11-1996 | CA | 2206246 A | 01-08-1996 |
| | | | CN | 1193853 A | 23-09-1998 |
| | | | CZ | 9702257 A | 18-03-1998 |
| | | | DE | 69601071 D | 14-01-1999 |
| | | | DE | 69601071 T | 15-07-1999 |
| | | | EP | 0806085 A | 12-11-1997 |
| | | | WO | 9623358 A | 01-08-1996 |
| | | | JP | 8320747 A | 03-12-1996 |
| | | | PL | 321324 A | 08-12-1997 |
| | | | US | 5568064 A | 22-10-1996 |
| EP 0620649 | A | 19-10-1994 | DE | 69405442 D | 16-10-1997 |
| | | | DE | 69405442 T | 02-04-1998 |
| | | | HK | 1002943 A | 25-09-1998 |
| | | | US | 5481207 A | 02-01-1996 |
| US 5760601 | A | 02-06-1998 | JP | 10093417 A | 10-04-1998 |

EPO FORM P0460

Pour tout renseignement concernant cette annexe : voir Journal Officiel de l'Office européen des brevets, No.12/82